# EUROPEAN PATENT APPLICATION

(11) **EP 4 734 146 A1**
(43) Date of publication of application: **29.04.2026**
(21) Application number: 24825677.8
(22) Date of filing: 29.05.2024
(51) Int. Cl.: H01J 37/073

(54) **EMITTER**

(30) Priority: 22.06.2023 JP 2023102230
(71) Applicant: Denka Company Limited, Tokyo 103-8338 (JP)
(72) Inventor: ISHIKAWA, Daisuke, Tokyo 103-8338 (JP)
(74) Representative: Hoffmann Eitle
(86) International application number: PCT/JP2024/019740
(87) International publication number: WO 2024/262270

(57) **Abstract**

An emitter comprises an insulator, a pair of terminals extending along a predetermined direction and fixed to the insulator so as to be separated from each other, a filament fixed to the pair of terminals, and a chip part formed of an electron emission material and fixed to the filament. Each of the pair of terminals has a fixing surface, and the fixing surface protrudes or is recessed in a direction perpendicular to the predetermined direction with respect to a surface of the terminal located on the insulator side of the fixing surface in the predetermined direction. The filament is fixed to the pair of terminals on the fixing surface. When the protruding height from the pair of terminals of the filament in the predetermined direction is designated as H and the length of the fixing surface in the predetermined direction is designated as **L,** L/H is 0.4 or less.

## Description

### TECHNICAL FIELD

One aspect of the present disclosure relates to an emitter.

### BACKGROUND

Patent Document 1 describes an emitter provided with an insulator, a pair of terminals fixed to the insulator, a filament fixed to the pair of terminals, and a chip part fixed to the filament. In this emitter, the chip part is heated by passing an electric current through the filament via the terminals, and an electron beam is emitted from the chip part.

### CITATION LIST

### PATENT LITERATURE

Patent Document 1: WO 2009/044871 A

### SUMMARY OF INVENTION

### TECHNICAL PROBLEM

An emitter such as that described above can be used in, for example, an electron microscope. In this case, if the filament vibrates due to resonance, the electron beam cannot be stably supplied, which may result in a decrease in the resolution of the electron microscope. Therefore, the emitter is required to suppress the resonant vibration of the filament and stably supply the electron beam.

Therefore, an object of one aspect of the present disclosure is to provide an emitter that can stably supply an electron beam.

### SOLUTION TO PROBLEM

The emitter according to one aspect of the present disclosure [1] "is provided with: an insulator; a pair of terminals extending along a predetermined direction and fixed to the insulator so as to be separated from each other; a filament fixed to the pair of terminals; and a chip part formed of an electron emission material and fixed to the filament, wherein each of the pair of terminals has a fixing surface, and the fixing surface protrudes or is recessed in a direction perpendicular to the predetermined direction with respect to a surface of the terminal located on the insulator side of the fixed surface in the predetermined direction, the filament is fixed to the pair of terminals at the fixing surface, and when the protruding height from the pair of terminals of the filament in the predetermined direction is designated as H and the length of the fixing surface in the predetermined direction is designated as L, L/H is 0.4 or less."

In the emitter, the portion comprising the filament and the chip part may vibrate due to resonance. Therefore, in order to stably supply an electron beam, increasing the resonant frequency of this portion to suppress the occurrence of vibrations due to resonance is considered. In this case, shortening the filament (reducing the protruding height from the terminals) is considered. This makes it possible to shorten the pendulum length of the portion comprising the filament and the chip part, and increases the resonant frequency of this portion. However, the present inventors have found that even if the filament is shortened and formed, simply fixing the filament to the terminals may not always result in a desired resonant frequency. That is, for example, if the filament is simply fixed to the terminals by welding, fine adjustment of the welding position is difficult, and therefore variations in the fixing positions of the filament to the terminals may occur. In this case, some of the resulting emitters may have a long filament length (the above-mentioned pendulum length) and a resonant frequency outside the desired range. Therefore, in the emitter of [1], each of the pair of terminals has a fixing surface that protrudes or is recessed in a direction perpendicular to the predetermined direction with respect to the surface of the terminal located on the insulator side of the fixing surface in the predetermined direction, and the filament is fixed to the pair of terminals at the fixing surfaces thereof. This makes it possible to suppress variations in the fixing position of the filament to the terminals, and to stably obtain desired resonance characteristics. Furthermore, in the emitter of [1], where the protruding height of the filament from the pair of terminals in the predetermined direction is designated as H and the length of the fixing surface in the predetermined direction is designated as L, L/H is 0.4 or less. The fixing position of the filament to the fixing surface may vary by the length L of the fixing surface. However, by reducing the length L of the fixing surface in this manner, desired resonance characteristics can be stably obtained regardless of the fixing position of the filament to the fixing surface. Therefore, with the emitter of [1], vibration due to resonance can be reliably suppressed, and an electron beam can be stably supplied.

An emitter according to one aspect of the present disclosure may be [2] "the emitter according to [1], wherein L/H is 0.2 or greater." In this case, it is possible to ensure the length L of the fixing surface, making it possible to ensure workability of fixing the filament to the fixing surface.

The emitter according to one aspect of the present disclosure may be [3] "the emitter according to [1] or [2], wherein the fixing surface is formed at an end part of the terminal on the side opposite the insulator." In this case, it is possible to simplify fixing the filament to the fixing surface. In addition, it is possible to shorten the length of the filament and it is possible to improve resonance characteristics.

The emitter according to one aspect of the present disclosure may be [4] "the emitter according to any one of [1]-[3], wherein the surface of the terminal is a bottom surface of a groove part formed in the terminal, and the fixing surface protrudes in a direction perpendicular to the predetermined direction with respect to the bottom surface of the groove part." The emitter according to one aspect of the present disclosure may be [5] "the emitter according to any one of [1]-[3], wherein the terminal has a protrusion part protruding in a direction perpendicular to the predetermined direction with respect to other portions in the terminal, and the fixing surface is a surface of the protrusion part." The emitter according to one aspect of the present disclosure may be [6] "the emitter according to any one of [1]-[3], wherein the fixing surface is a bottom surface of a groove part or a recess part formed in the terminal, and is recessed in a direction perpendicular to the predetermined direction with respect to the surface." In the cases of [4]-[6], it is possible to reliably suppress vibrations due to resonance and it is possible to stably supply an electron beam."

### EFFECTS OF THE INVENTION

According to one aspect of the present disclosure, it is possible to provide an emitter that can stably supply an electron beam.

### BRIEF DESCRIPTION OF DRAWINGS

FIG. 1 is a front view of an emitter according to an embodiment.
FIG. 2 is a plan view of the emitter.
FIG. 3 is a schematic perspective view of the emitter.
FIG. 4 is a schematic perspective view of an emitter according to a first modified example.
FIG. 5 is a schematic perspective view of an emitter according to a second modified example.

### DESCRIPTION OF EMBODIMENTS

Hereinafter, embodiments of the present disclosure will be described in detail with reference to the drawings. In the following description, the same or equivalent elements will be designated by the same reference numbers, and redundant descriptions will be omitted.

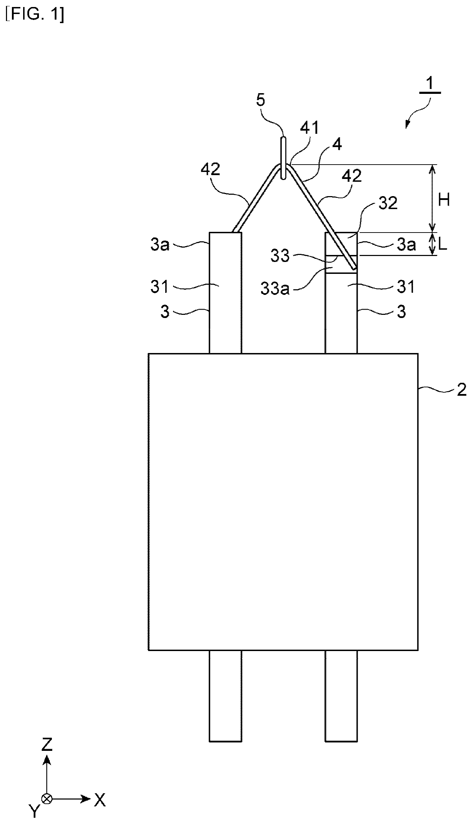

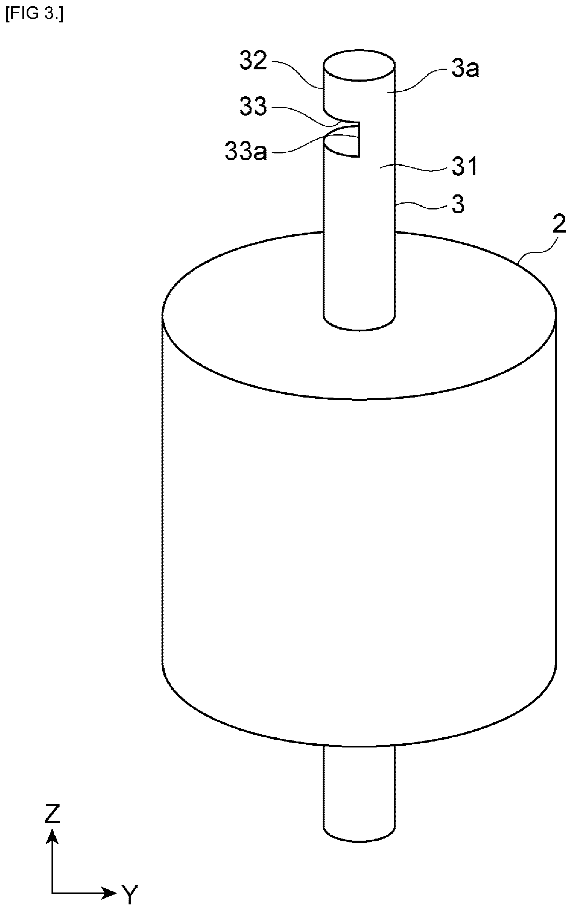

As shown in FIGS. 1 to 3, the emitter 1 includes an insulator 2, a pair of terminals 3, a filament 4, and a chip part 5 (electron source). The emitter 1 is, for example, a thermal field emission type emitter. The emitter 1, together with a suppressor electrode and an extraction electrode, constitutes an electron gun and can be used in electron microscopes, semiconductor manufacturing equipment, inspection equipment, and processing equipment. In the emitter 1, the chip part 5 is heated by passing an electric current through the filament 4 via the pair of terminals 3, and an electron beam is emitted from the tip of the chip part 5. The emitter 1 may also be a cold field emission type emitter. The following description will be made with reference to the X direction, the Y direction perpendicular to the X direction, and the Z direction (the predetermined direction) perpendicular to the X and Y directions shown in each drawing. Note that the filament 4 and chip part 5 are omitted in FIG. 3, and only one of the pair of terminals 3 is shown.

The insulator 2 is formed, for example, in a substantially cylindrical shape from an insulating material. The terminals 3 are formed, for example, in a rod shape from a metal material such as tungsten, titanium, Kovar, or niobium. In this example, the terminals 3 are formed in a cylindrical shape and extend straight along the Z direction. The terminals 3 penetrate the insulator 2 along the Z direction and are fixed to the insulator 2 at their middle portions. The terminals 3 have a protrusion part 31 that protrudes from the insulator 2 to one side in the Z direction (the upper side in each drawing). The pair of terminals 3 face each other at a distance in the X direction.

The filament 4 is formed in an arch shape, extends between the pair of terminals 3, and is fixed to the pair of terminals 3 at both ends. The filament 4 has an apex part 41 and a pair of extension parts 42 that extend from the apex part 41 toward both ends. The apex part 41 is curved so as to be convex toward one side in the Z direction (the side opposite the insulator 2 and terminals 3). In this example, the extension parts 42 extend straight. The filament 4 is fixed to the protrusion part 31 of each terminal 3 at the extension parts 42. The extension parts 42 are fixed to the protrusion parts 31 by, for example, spot welding. Details of the fixing of the filament 4 to the terminals 3 will be described later.

The filament 4 is formed from a high-melting-point metal having a melting point of, for example, 2200° C or higher. In this example, the filament 4 is formed from tungsten. Other examples of the material of the filament 4 include an alloy of tungsten and a high-melting-point metal (e.g., rhenium). The material of the filament 4 may also be tungsten doped with an alkali metal (e.g., potassium) for structural stabilization.

The chip part 5 is fixed to the apex part 41 of the filament 4. The chip part 5 is formed, for example, in a rod (needle) shape from an electron emission material. Examples of materials for the chip part 5 include high-melting-point metals such as tungsten, tantalum, and hafnium, as well as their oxides, carbides, and nitrides, rare-earth borides such as lanthanum boride (LaB6) and cerium boride (CeB6), and precious metal-rare earth alloys such as iridium-cerium. In this example, the chip part 5 is fixed so as to extend along the Z direction.

The details of the fixation of the filament 4 to the terminals 3 will now be described. The protrusion part 31 of each terminal 3 has a fixing surface 32 to which the filament 4 is fixed. In this example, a groove part 33 extending along the X direction is formed in the protrusion part 31, and the surface of a portion of the terminal 3 located on one side of the groove part 33 in the Z direction (upper side in the drawing) serves as the fixing surface 32. That is, the fixing surface 32 is a part of the surface of the terminal 3, and in this example, is a cylindrically curved surface. The fixing surface 32 is formed on the end part 3a of the terminal 3 (protrusion part 31) opposite the insulator 2. The groove part 33 is formed, for example, in a rectangular shape in a cross section perpendicular to the X direction. The groove part 33 is formed so as to penetrate the terminal 3 along the X direction (throughout the entire terminal 3 in the X direction). The fixing surface 32 may be a flat surface perpendicular to the Y direction. For example, the terminal 3 may be processed so that the fixing surface 32 is flat.

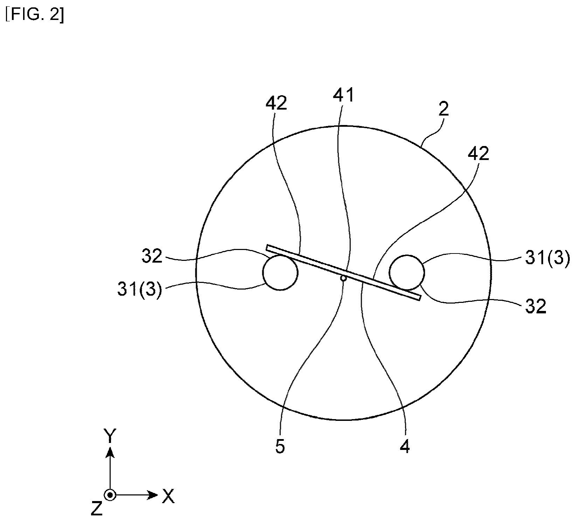

The filament 4 is fixed to the terminal 3 located on one side in the X direction (the right side in FIGS. 1 and 2) on one side in the Y direction (the front side of the page in FIG. 1 and the lower side in FIG. 2), and is fixed to the terminal 3 located on the other side in the X direction (the left side in FIGS. 1 and 2) on the other side in the Y direction (the back side of the page in FIG. 1 and the upper side in FIG. 2). That is, the fixing surface 32 and the groove part 33 are provided on one side in the Y direction for the terminal 3 on one side in the X direction, and on the other side in the Y direction for the terminal 3 on the other side in the X direction. As a result, as shown in FIG. 2, the chip part 5 is located between the pair of terminals 3 when viewed from the Z direction.

The fixing surface 32 protrudes in the Y direction relative to the bottom surface 33a of the groove part 33. The bottom surface 33a is a surface of the terminal 3 that is located on the insulator 2 side of the fixing surface 32 in the Z direction (the lower side in each drawing), and is adjacent to the fixing surface 32 in the Z direction. In the terminal 3 located on one side in the X direction (the right side in FIGS. 1 and 2), the fixing surface 32 protrudes to one side in the Y direction (the front side of the page in FIG. 1 and the lower side in FIG. 2) relative to the bottom surface 33a of the groove part 33, and in the terminal 3 located on the other side in the X direction (the left side in FIGS. 1 and 2), the fixing surface 32 protrudes to the other side in the Y direction (the back side of the page in FIG. 1 and the upper side in FIG. 2) relative to the bottom surface 33a of the groove part 33.

The filament 4 is fixed to each terminal 3 at the fixing surface 32 by welding. That is, the fixing surface 32 functions as a welding surface for welding the filament 4 to the terminals 3.

If the protruding height of the filament 4 from the terminal 3 in the Z direction is designated as H and the length (maximum length) of the fixing surface 32 in the Z direction is designated as L ( FIG. 1 ), then L/H, which is the ratio of the protruding height H of the filament 4 to the length L of the fixing surface 32, is 0.2 or more and 0.4 or less. As an example, the protruding height H of the filament 4 is approximately 1.5 mm, and the length L of the fixing surface 32 is approximately 0.4 mm. In this case, L/H is 0.27. L/H is preferably 0.3 or less. The length L of the fixing surface 32 is, for example, 0.6 mm or less, and preferably 0.5 mm or less.

### [Functions and Effects]

In the emitter 1, each terminal 3 has a fixing surface 32 that protrudes in the Y direction (a direction perpendicular to the Z direction) from the bottom surface 33a of the groove part 33 (the surface of the terminal 3 that is located on the insulator 2 side of the fixing surface 32 in the Z direction), and the filament 4 is fixed to each terminal 3 at the fixing surface 32. This suppresses variation in the fixing positions of the filament 4 to the terminals 3, thereby stably achieving desired resonance characteristics. Furthermore, in the emitter 1, where the protruding height of the filament 4 from the terminal 3 in the Z direction is designated as H and the length of the fixing surface 32 in the Z direction is designated as L, L/H is 0.4 or less. Although the fixing position of the filament 4 to the fixing surface 32 may vary by the length L of the fixing surface 32, by reducing the length L of the fixing surface 32 in this manner, desired resonance characteristics can be stably obtained regardless of the fixing position of the filament 4 to the fixing surface 32. That is, in the above embodiment, the fixing positions of the filament 4 to the terminals 3 can be reliably controlled within a range from the end part 3a of the terminal 3 to the length L of the fixing surface 32 or less. Therefore, with the above emitter 1, it is possible to reliably suppress vibrations due to resonance and to stably supply electron beams.

The ratio L/H is 0.2 or more. This ensures the length L of the fixing surface 32, and ensures the workability of fixing (welding) the filament 4 to the fixing surface 32.

The fixing surface 32 is formed on the end part 3a of the terminal 3 opposite to the insulator 2. This makes it easier to fix (weld) the filament 4 to the fixing surface 32. Furthermore, the length of the filament 4 can be shortened, improving the resonance characteristics.

The fixing surface 32 protrudes in the Y direction from the bottom surface 33a of the groove part 33. In this case as well, vibration due to resonance can be reliably suppressed, and the electron beam can be supplied stably.

### [Modified Examples]

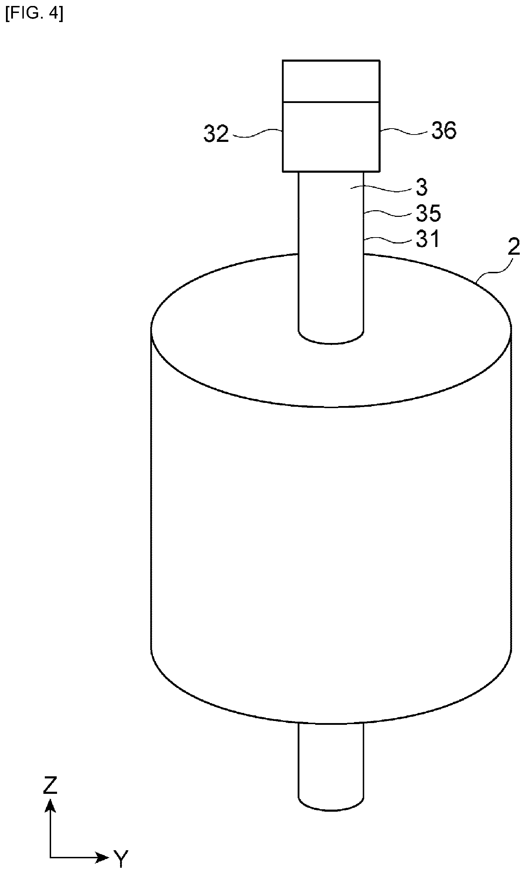

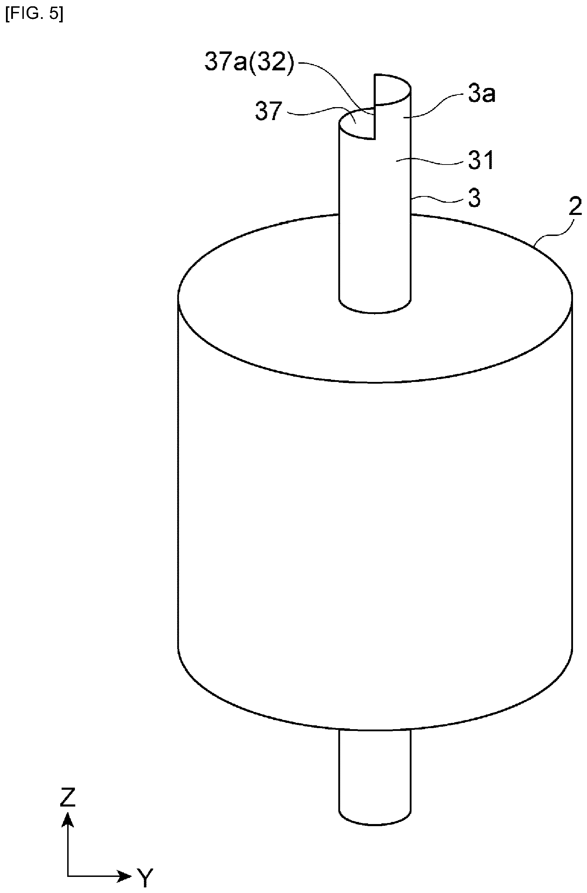

The fixing surface 32 may be configured as shown in FIG. 4 or FIG. 5. In FIG. 4 and FIG. 5, similarly to FIG. 3, the filament 4 and the chip part 5 are omitted, and only one of the pair of terminals 3 is shown.

In a first modified example shown in FIG. 4, the terminal 3 has a cylindrical main body part 35 and a protrusion part 36 that protrudes in the Y direction relative to the main body 35 (other portions of the terminal 3). The protrusion part 36 is formed, for example, in a rectangular parallelepiped shape, and protrudes from the main body part 35 along its entire circumference when viewed from the Z direction. In the first modified example, the fixing surface 32 is a flat surface formed by the surface of the protrusion part 36. The fixing surface 32 protrudes in the Y direction relative to the surface (cylindrical surface) of the main body part 35 (the surface of the terminal 3 that is located on the insulator 2 side of the fixing surface 32 in the Z direction).

In a second modified example shown in FIG. 5, a recess part 37 is formed in the end part 3a of the terminal 3 (protrusion part 31) opposite the insulator 2, and the bottom surface 37a of the recess part 37 forms the fixing surface 32. In this case, the fixing surface 32 is recessed in the Y direction with respect to the surface (cylindrical surface) of the terminal 3 that is located on the insulator 2 side of the fixing surface 32 in the Z direction. The recess part 37 is formed in a semicircular shape when viewed from the Z direction, for example, and the bottom surface 37a is a rectangular flat surface.

The first and second modified examples also reliably suppress vibrations due to resonance and stably supply electron beams. In the first modified example, the protrusion part 36 may have any shape. In the second modified example, a groove part may be formed in the terminal 3 instead of the recess part 37, and the fixing surface 32 may be formed by the bottom surface of the groove part. In other words, in the example of FIG. 3, the fixing surface 32 may be formed by the bottom surface 33a of the groove part 33.

The present disclosure is not limited to the above-described embodiment and modified examples. For example, the materials and shapes of each component are not limited to those described above, and various materials and shapes can be employed. In the above-described embodiment, the fixing surface 32 is provided on one side in the Y direction for the terminal 3 on one side in the X direction, and on the other side in the Y direction for the terminal 3 on the other side in the X direction. However, the fixing surface 32 may be provided on the same side in the Y direction for the pair of terminals 3. That is, both ends of the filament 4 may be fixed on one side in the Y direction to the pair of terminals 3.

In the above embodiment, the emitter 1 is provided with one filament 4 (first filament 4), but it may also include multiple (e.g., two) filaments 4. In this case, for example, each terminal 3 has fixing surfaces 32 on both sides in the Y direction, and the second filament 4 is fixed to the fixing surfaces 32 opposite to the fixing surfaces 32 to which the first filament 4 is fixed. The second filament 4 supports the chip part 5 from the side opposite to the first filament 4. That is, for example, the chip part 5 may be fixed to the apex parts 41 of each of the first filament 4 and the second filament 4, and the chip part 5 may be supported so as to be sandwiched by these apex parts 41 in the Y direction.

### REFERENCE SIGNS LIST

1 Emitter
2 Insulator
3 Terminal
3a End part
4 Filament
5 Chip part
32 Fixing surface
33 Groove part
33a Bottom surface
36 Protrusion part
37 Recess part
37a Bottom surface

## Claims

1. An emitter comprising:
an insulator;
a pair of terminals extending along a predetermined direction and fixed to the insulator so as to be separated from each other;
a filament fixed to the pair of terminals; and
a chip part formed of an electron emission material and fixed to the filament, wherein
each of the pair of terminals has a fixing surface, and the fixing surface protrudes or is recessed in a direction perpendicular to the predetermined direction with respect to a surface of the terminal located on the insulator side of the fixing surface in the predetermined direction,
the filament is fixed to the pair of terminals at the fixing surface, and
when the protruding height from the pair of terminals of the filament in the predetermined direction is designated as H and the length of the fixing surface in the predetermined direction is designated as L, L/H is 0.4 or less.

2. The emitter according to claim 1, wherein L/H is 0.2 or greater.

3. The emitter according to claim 1 or 2, wherein the fixing surface is formed at an end part of the terminal on the side opposite the insulator.

4. The emitter according to claim 1 or 2, wherein
the surface of the terminal is a bottom surface of a groove part formed in the terminal, and
the fixing surface protrudes in a direction perpendicular to the predetermined direction with respect to the bottom surface of the groove part.

5. The emitter according to claim 1 or 2, wherein
the terminal has a protrusion part protruding in a direction perpendicular to the predetermined direction with respect to other portions in the terminal, and
the fixing surface is a surface of the protrusion part.

6. The emitter according to claim 1 or 2, wherein the fixing surface is a bottom surface of a groove part or a recess part formed in the terminal, and is recessed in a direction perpendicular to the predetermined direction with respect to the surface of the terminal.
